# EUROPEAN PATENT SPECIFICATION

(11) **EP 4 254 599 B1**
(45) Date of publication and mention of the grant of the patent: **28.01.2026**
(21) Application number: 20963397.3
(22) Date of filing: 30.11.2020
(51) Int. Cl.: H01M 10/48, G01R 31/36, G01R 31/382, G01R 31/392

(54) **BATTERY CELL AND BATTERY WITH MEANS FOR DETECTING STATE OF HEALTH (SOH) AND STATE OF CHARGE (SOC)**
BATTERIEZELLE UND BATTERIE MIT MITTELN ZUR ERKENNUNG DES GESUNDHEITSZUSTANDS (SOC) UND DES LADEZUSTANDS (SOC)
CELLULE DE BATTERIE ET BATTERIE AVEC MOYENS DE DÉTECTION DE SOH ET DE SOC

(43) Date of publication of application: 04.10.2023
(73) Proprietor: Asociacion Centro Tecnologico Ceit, 20018 Donostia - San Sebastian (Gipuzkoa) (ES); Gelion Technologies PTY LTD, North Sydney NSW 2060 (AU)
(72) Inventor: GALARZA RODRIGUEZ, Ainhoa, 20018 Donostia (Gipuzkoa) (ES); AYERDI OLAIZOLA, Isabel, 20018 Donostia (Gipuzkoa) (ES); CASTAÑO CARMONA, Enrique, 20018 Donostia (Gipuzkoa) (ES); DESILANI, Sebastien, 60325 Frankfurt am Main (DE); ULISSI, Ulderico, Milton Keynes MK10 7HB (GB)
(74) Representative: Nederlandsch Octrooibureau
(86) International application number: PCT/ES2020/070746
(87) International publication number: WO 2022/112622

(56) References cited:
- US-A1- 2015 132 621
- US-A1- 2016 380 317
- US-A1- 2020 076 016
- US-A1- 2020 076 016
- LORENTZ, VICENT RH ET AL.: "Novel cost-efficient contactless distributed monitoring concept for smart battery cells", IEEE INTERNATIONAL SYMPOSIUM ON INDUSTRIAL ELECTRONICS, 2012, pages 1342 - 1347, XP002728497, DOI: 10.1109/ISIE.2012.6237285
- CHOI WOOHYUK; SEO YOUNGNO; YOO KISOO; KO TAE JO; CHOI JUNGWOOK: "Carbon Nanotube-Based Strain Sensor for Excessive Swelling Detection of Lithium-Ion Battery", 2019 20TH INTERNATIONAL CONFERENCE ON SOLID-STATE SENSORS, ACTUATORS AND MICROSYSTEMS & EUROSENSORS XXXIII (TRANSDUCERS & EUROSENSORS XXXIII), IEEE, 23 June 2019 (2019-06-23), pages 2356 - 2359, XP033600086, DOI: 10.1109/TRANSDUCERS.2019.8808477

## Description

### Technical field

This invention relates to a rechargeable electric battery, preferably for a battery cell with means for calculating its SoH and SoC.

### Background

An electric battery is a device consisting of one or more electrochemical cells that can convert the stored chemical energy into electric current. Electrochemical cells come in many shapes and sizes, such as cylindrical, button, prismatic, and bag. In particular, bag cells have been gaining popularity in recent years as they offer a simple, flexible, and lightweight solution for battery design.

Determining the State of Charge (SoC) and State of Health (SoH) of a battery is a really critical issue for managing energy performance and increasing battery life.

Specifically, the SoC represents the charge level of a battery in relation to its capacity. The most common way to represent the SoC is in percentage (0% = empty; 100% = full).

The SoH represents the state of a battery compared to its ideal conditions. The most used units to represent the SoH are percentages (100% = battery conditions match battery specifications). Generally, the SoH of a battery will be at 100% at the time of manufacture and decrease over time and use.

Over the years, several methods have been proposed for the determination of SoC and SoH of batteries, one of the most widely used is based on the use of electrical measurements of battery voltages and currents, such as Patent document EP3671939A1. These measurements, together with different extrapolation algorithms, allow estimating the battery impedance, a parameter directly related to the SoC and SoH.

However, the impedance in current batteries can be less than 1 mOhm; therefore, the measurement methods and necessary hardware must overcome specific requirements, substantially increasing the battery cost.

US2015132621A1 discloses an encasing film for a galvanic element has at least one force sensor for detecting an expansion state of the encasing film. The encasing film is produced from an elastic and electrically insulating material, e.g., plastic. The force sensor, which has a strain gauge, is situated on a surface of the encasing film. US2020076016A1 discloses a battery pouch. The battery pouch including an outer layer and an inner layer disposed on the outer layer. The inner layer including at least one sensor.

Another effective approach to predict the battery performance is based on real-time measurement of the change in the cell internal conditions that constitute the battery, using extremely sensitive and low-cost sensors.

The charge and discharge cycle of the battery cell induces microstructural changes in the electrodes and electrolytes that result in cyclic cell deformations related to the degradation of the device. Therefore, a low-cost non-invasive sensor capable of detecting the cell volume variation is a very suitable tool to relate the mechanical stress to the cell chemical degradation, and thereby estimating the SoC and SoH of the battery.

One of the most used non-invasive measurement strategies of the battery physical properties for the SoC and SoH estimation is measuring the cell surface deformation.

One such method for measuring the cell surface deformation is the optical measurement, but this method has the disadvantage of excessive cost and integration difficulty into the battery.

Another method for measuring the cell surface deformation is using a deformation sensor glued on the cell surface, such as in Patent document US20200014074A1. This method has a main disadvantage in that the glue acts as an insulator between the deformation sensor and the cell surface, thereby interfering with the process of obtaining data, leading to errors, and interfering with the manufacturing process.

Therefore, it is necessary to develop an electrochemical cell with a deformation sensor integrated directly on the cell surface, which allows to obtain a correct measurement of the deformation with the minimum of errors and has a low integration cost.

### Object of the invention

In view of all the foregoing, an object of this invention is a battery cell in the form of a bag, comprising a sensor fixed to the outside surface of the bag comprising a plurality of sensing elements of the same material, at least one conducting element and, optionally, at least one resistor element, the conducting element connecting the sensing element and/or the resistor element together,wherein the sensing element, the conducting element and/or the resistor element are respectively obtained by separately depositing portions of material of sensing element, of conducting element or of resistor element on the outside surface of the bag.

As the different elements of the sensor are deposited directly on the outside surface of the cell bag is possible to avoid the presence of different intermediate elements, such as adhesives, substrates, etc. that can interfere with the measurement of the deformation of the bag surface, and therefore interfere with the estimation of SoC and SoH of the battery.

Furthermore, by separately depositing portions of material of the sensing element, conducting element or resistor element is possible that the sensing element, conducting element or resistor element are composed of varied materials more suitable for the function they perform.

Preferably, the sensing element is a deformation and/or temperature sensing element constituted by piezoresistive and/or thermoresistive material deposited on the outside surface of the bag.

For a better data acquisition of the properties of the outside surface of the bag, and thus obtaining a better estimation of the SoC and SoH of the battery, one of the sensing elements is a deformation sensing element, configured for the detection of the surface deformation of the cell bag. Likewise, another sensing element is a temperature sensing element for measuring the surface temperature of the bag. In this way, with the data obtained by the deformation sensing element and the temperature sensing element, the SoC and SoH of the battery are estimated.

On the other hand, although it may be possible to estimate the SoC and SoH with only one of either the temperature sensing element or the deformation sensing element, a more accurate estimation is achieved with the combination thereof.

By varying the electrical resistance of the piezoresistive material, primarily in relation to the material deformation, it becomes a suitable material for constituting the deformation sensing element; likewise, by varying the electrical resistance of the thermoresistive material, primarily because of its temperature, it becomes the suitable material for the temperature sensing element. According to the invention, the cell comprises a plurality of sensing elements of the same sensing element material, thereby decreasing the manufacturing cost and ensuring that the measurements obtained are consistent among the different sensing elements.

According to an aspect of the invention, the temperature sensing element is arranged substantially in the center of the bag, i.e., at a midway point of the bag equidistant from its outline. The center of the outside surface of the bag is expected to be the position where the surface deformation of the bag is lower. In this way, the change in electrical resistance of the temperature sensing element would be related almost exclusively to the temperature of the material without interfering with the measurement of the deformation of the bag itself.

Preferably, the temperature sensing element is substantially square in shape. This configuration allows the deformation of the temperature sensing element to be uniform, derived in turn by its central positioning, and consequently deforming the same in all directions. Therefore, the change in electrical resistance of the temperature sensing element with respect to the deformation of the outside surface of the bag is further decreased, improving the data acquisition.

Additionally, and preferably, the sensing element and the resistor element are connected to form a Wheatstone bridge. This ensures that the change in resistance of the sensing element due to the change in temperature of the material of the sensing element does not mask the change in resistance of the sensing element due to the surface deformation of the bag, resulting in a more accurate data acquisition.

On the other hand, the deposition of portions of material of sensing, resistor or conducting element is performed by sputtering or printing. In this way, the sensor is fixed to the bag surface, eliminating the need for substrates or adhesives that could interfere with the data acquisition.

Preferably, the sensing element, resistor element and/or conducting element are arranged forming different respective layers on the outside surface of the bag. In this way, the manufacturing process of the sensor is homogenized in various stages, each one corresponding to the sensing element, resistor element and/or conducting element. This results in an optimization of each of the elements that constitutes the sensor.

Preferably, the sensor comprises a passivating layer applied to the sensing element, resistor element and conducting element. This passivating layer increases the mechanical resistance of the sensing element, resistor element and conducting element to oxidation, surface scratches, etc.

It is envisaged that the subject cell of the invention has an anode constituted by Lithium metal, and that the cell is selected among a lithium-sulfur, lithium-air, solid-state lithium ion or lithium-NMC cell, preferably the solid-state Li-S. The subject cell configuration of the invention is of particular interest for the data acquisition of the properties of the outside surface of the bag in the case of Li-metal cells, since the bag undergoes significant volume changes during each charge and discharge cycle, due to the significant increase/decrease of the Li anode thickness. Therefore, with the above-described sensor configuration, such deformations are detected, obtaining a better estimation of the SoC and SoH of the battery.

Also, for Li-S cells in which heat is easily generated during each cycle of the battery due to the insulating nature of the sulfur, the subject configuration of the invention of the various sensing elements comprised in the cell bag is particularly relevant, such that changes due to temperature and deformation are more effectively detected, for a better estimation of the SoC and SoH of the battery.

Also, an object of the invention is a battery comprising said electrochemical cell for the calculation of its SoH and SoC. Preferably, a battery with at least one Lithium metal cell and more preferably Li-S cell, such as solid-state Li-S batteries.

### Description of the figures

Figure 1 shows a plan view of an example bag-type cell of the state of the art.
Figure 2 shows a plan view of an example embodiment of a cell with the sensor deposited on the bag surface.
Figure 3 shows a plan view of an example embodiment of a cell with the sensor and conducting element deposited on the bag surface.
Figures 4A, 4B and 4C show the phases for printing the sensor, conducting element, and passivating layer on the bag surface by the sputtering method.

### Detailed description of the invention

In view of the aforementioned figures, and in accordance with the numbering adopted, an example of preferred embodiment of the invention can be observed therein, which comprises the parts and elements indicated and described in detail below.

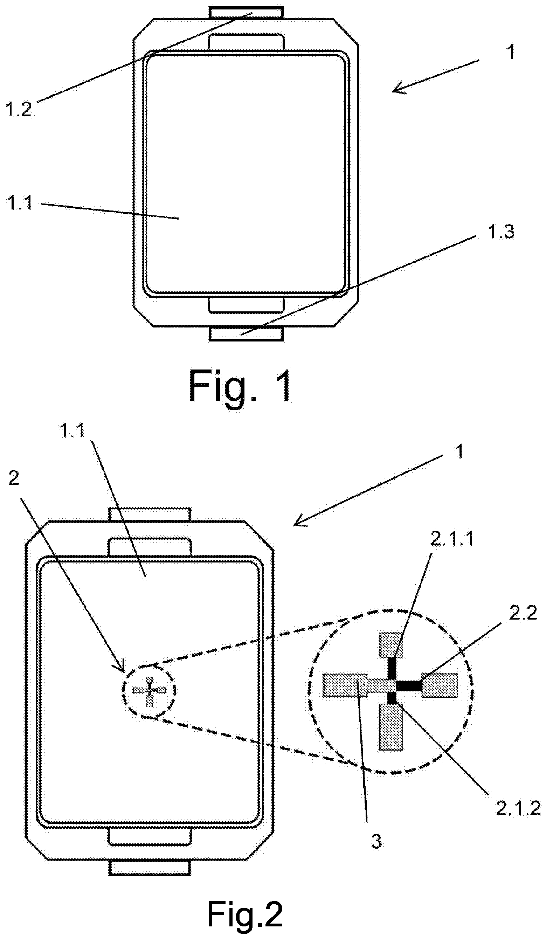

Figure 1 shows an example of an electrochemical cell (1) of the state of the art, specifically showing a cell (1) with a bag (1.1), said bag (1.1) preferably having a rectangular shape. As can be observed in figure 1, the cell (1) comprises, at one end of the bag (1.1), a positive terminal (1.2), and at the opposite end protrudes a negative terminal (1.3), it is at said positive terminal (1.2) and negative terminal (1.3) where the connection with the electrical circuit outside the cell (1) occurs.

Figure 2 shows a cell (1) with a sensor (2) printed on the bag surface (1.1); in this example of preferred embodiment, the sensor (2) is comprised of two sensing elements (2.1.1, 2.1.2) and a resistor element (2.2) connected together. Specifically, the sensing elements are a deformation sensing element (2.1.1) and a temperature sensing element (2.1.2).

Preferably, the material of the deformation sensing element (2.1.1) and the resistor element (2.2) is a piezoresistive material, the temperature sensing element (2.1.2) is a thermoresistive material. The piezoresistive material has the property that its electrical resistance changes when it undergoes a mechanical stress or strain (traction or compression) that deforms it. Such change may be due either to the variation of the interatomic distance or the variation of the carrier concentrations. The electrical resistance of piezoresistive materials can also depend on temperature, hence the need for the Wheatstone bridge configuration with the resistor element (2.2).

Different, non-limiting examples of piezoresistive materials are: NiO, NiCr, TaN, TaNO, etc.

The thermoresistive material has the property that its electrical resistance changes mainly when it undergoes a temperature change, without producing electrical potential, which makes it a truly relevant material for the conformation of temperature sensing elements (2.1.2).

Different, non-limiting examples of thermistor materials are: NiO, Pt, Ag, etc.

To simplify the manufacturing process, and therefore, reduce the cell manufacturing cost, the deformation sensing element (2.1.1), the temperature sensing element (2.1.2) and the resistor element (2.2) are made of the same material, preferably one that can function as piezoresistive and thermoresistive material.

As can be observed in figure 2, the temperature sensing element (2.1.2) is preferably deposited in the center of the outside surface of the bag (1.1). At this location it is expected that the surface deformation of the bag (1.1) is uniform and the lowest of the entire bag surface (1.1). Thus, the interferences due to the outside surface deformation of the bag (1.1) in the temperature measurement are reduced, the temperature sensing element (2.1.2) being deformed exclusively by the action of temperature variations.

Said center of the outside surface of the bag (1.1) is defined by being at an equidistant distance between the four edges of the bag (1.1) when it houses a battery cell.

Preferably, this temperature sensing element (2.1.2) has a substantially square shape, thus the change of electrical resistance of the temperature sensing element (2.1.2) due to cell deformation will be minimal. Uniform deformation is obtained in all directions of the material of the temperature sensing element (2.1.2), such that the measured data are more dependable.

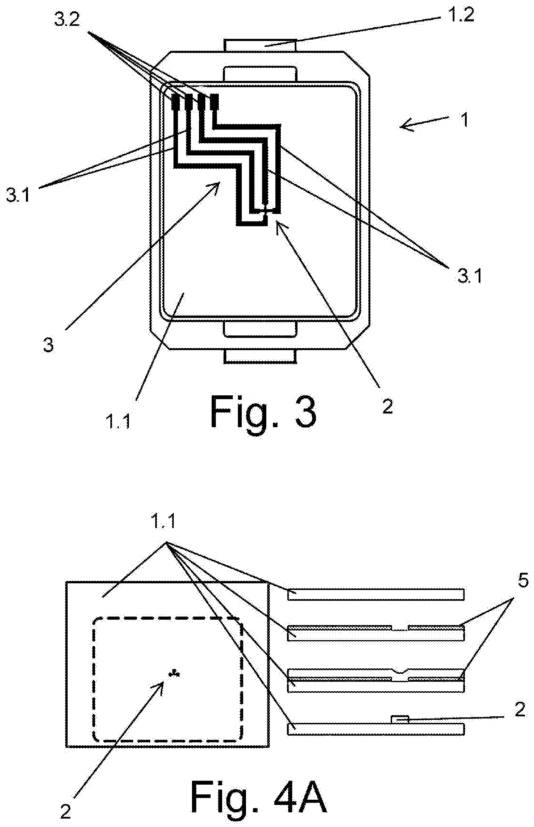

As can be observed in figure 3, a conducting element (3) is deposited on the outside surface of the bag (1.1) for transmitting the electrical signal. This conducting element (3) comprises tracks (3.1) connecting the deformation sensing element (2.1.1), the temperature sensing element (2.1.2) and the resistor element (2.2) to terminals (3.2) preferably located on a margin of the outside surface of the bag (1.1) close to the positive terminal (1.2).

Such terminals would then connect a PCB for transmitting the data obtained from the sensors.

Preferably, the selected methods for depositing the sensing elements (2.1.1, 2.1.2), resistor element (2.2) and conducting element (3) in the bag (1.1) are sputtering and applying the liquid material in the form of ink, for example, integrated in a roll-to-roll process. It should be noted that both processes are set forth as examples and are not limiting.

The sputtering method is a physical process in which the atoms of a solid material are vaporized by sputtering it with energetic ions. This process is widely used in the formation of thin films on materials, etching techniques, and analytical techniques.

Once the deformation sensing element (2.1.1), temperature sensing element (2.1.2), resistor element (2.2) and conducting element (3) are deposited on the outside surface of the cell (1) bag (1.1), a passivating layer (4) is deposited on the outside surface of the bag (1.1), such that it covers the deformation sensing element (2.1.1), temperature sensing element (2.1.2), the resistor element (2.2) and the conducting element (3), except for the terminals (3.2) of the conducting element (3).

This passivating layer (4) protects the deformation sensing element (2.1.1), temperature sensing element (2.1.2), the resistor element (2.2) and the conducting element (3) from surface scratches, oxidation, etc.

A non-limiting example of the passivating layer material (4) is Plastik70 compound, a commercial compound for coating printed circuit boards.

In this practical example embodiment of this invention, the sputtering is divided into four phases, depositing the deformation sensing element (2.1.1), the temperature sensing element (2.1.2) and the resistor element (2.2), depositing the conducting element (3), curing of the deposited material on the bag surface (1.1) and depositing the passivating layer (4).

As can be observed in figure 4A, the deposition of the material of the deformation sensing element (2.1.1), temperature sensing element (2.1.2) and resistor element (2.2), preferably piezoresistive material such as NiO, is divided into three sub-phases:
- Use of a rigid mask layer (5) on the bag surface (1.1). This mask facilitates subsequent deposition of the material by sputtering.
- Depositing the material of the deformation sensing element (2.1.1), the temperature sensing element (2.1.2) and the resistor element (2.2) on the bag surface (1.1). Preferably, a layer of about 100nm - 1µm NiO is deposited.
- Removal of the mask layer (5), with the deformation sensing element (2.1.1), the temperature sensing element (2.1.2) and the resistor element (2.2) remaining attached to the bag surface (1.1).

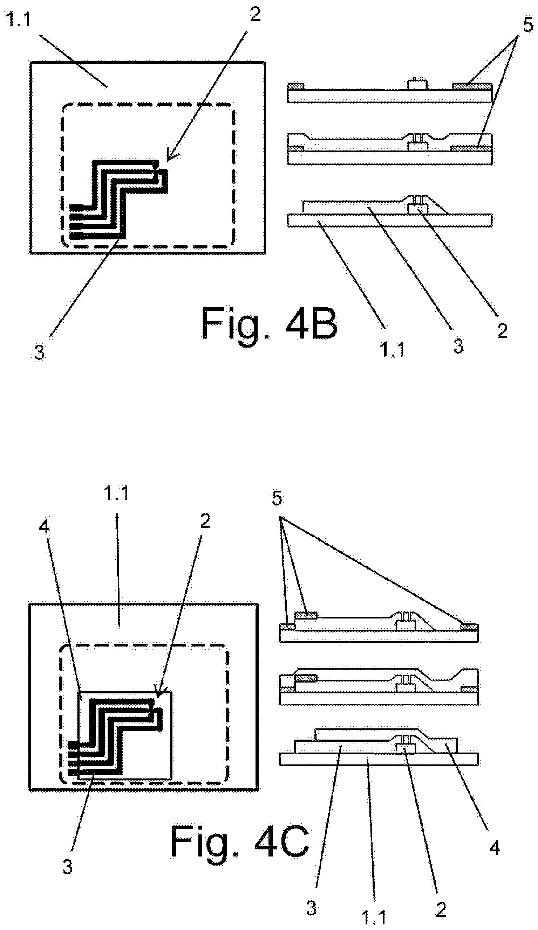

Likewise, as can be observed in figure 4B, the deposition of the conducting element material (3), preferably conducting material such as Ag, is divided into three sub-phases:
- Use of a rigid mask layer (5) on the bag surface (1.1).
- Depositing the conducting element material (3), preferably a layer of about 100nm - 1µm Ag is deposited. For better adhesion between the bag (1.1) and the Ag layer a Cr layer of about 10nm - 50nm is used.
- Removal of the mask layer (5), leaving only the deformation sensing element (2.1.1), the temperature sensing element (2.1.2), the resistor element (2.2) and the conducting element (3) on the bag surface (1.1).

Once the material of the deformation sensing element (2.1.1), the temperature sensing element (2.1.2), the resistor element (2.2) and the conducting element (3) has been deposited, the material is cured for one hour at 120°C.

Finally, as can be observed in figure 4C, the deposition of the passivating layer (4) is divided into three sub-phases:
- Use of a rigid mask layer (5) on the bag surface (1.1).
- Depositing the passivating layer material (4) on the bag surface (1.1). Removal of the mask layer (5), leaving only the deformation sensing element (2.1.1), the temperature sensing element (2.1.2), the resistor element (2.2), the conducting element (3) and the passivating layer (5) on the bag surface (1.1).

According to another embodiment, the deposition of portions of material for obtaining the deformation sensing element (2.1.1), the temperature sensing element (2.1.2), resistor element (2.2), conducting element (3) and the passivating layer (4) on the bag surface (1.1) is carried out by ink and/or pastes direct printing on the outside surface of the bag (1.1).

It is a low-cost manufacturing alternative and, in this case, as the bag (1.1) is a flexible material, it allows the integration of the entire manufacturing process in a roll-to-roll system, which in turn enables the processing of large surfaces at high speed.

This example embodiment of this invention comprising printing is divided into four phases:
- A first printing of the conducting element (3) on the bag surface (1.1) by a conducting ink (e.g., silver or graphite) and its subsequent curing to define the tracks (3.1) and the terminals (3.2).
- The deformation sensing element (2.1.1) and the resistor element (2.2) are then printed onto the bag surface (1.1) by a piezoresistive ink (mainly conducting polymers, e.g., poly(3,4-ethylenedioxythiophene)-poly(styrene sulfonate), or polymeric matrices with embedded conducting particles, e.g., PDMS or polyimides with metal nanoparticles or carbon nanotubes), followed by curing.
- The temperature sensing element (2.1.2) can be deposited using the same material and process as the one of the deformation sensing element or constitute a subsequent process optimizing the thermoresistive material.
- Finally, the dielectric passivating layer (4) is printed, followed by a final curing step.

The printing techniques currently available are numerous (flatbed & rotary screen-printing, inkjet printing, microdispensing, aerosol printing, flexographic printing, gravure, etc.) and all of them are valid for printing the sensor (2).

After depositing the deformation sensing element (2.1.1), the temperature sensing element (2.1.2), the resistor element (2.2), the conducting element (3) and the passivating layer (4) on the bag surface (1.1), by any of the methods described above, tests were performed to relate the data obtained by the sensors to the SoC and SoH of the battery.

In order to originally focus the study on the data obtained from the deformation sensing element (2.1.1), the tests were performed in a climatic chamber at constant temperature.

To correlate the deformation sensing element (2.1.1) data with the SoH of the battery, the maximum deformation (εₘₐₓ), minimum deformation (εₘᵢₙ), mean deformation (εₘₑₐₙ) and deformation range (Δε = εₘₐₓ - εₘᵢₙ) has been compared with the SoH of the battery.

The minimum deformation and mean deformation show the most solid relationship with SoH. However, both are based on deformation values during each charge and discharge cycle and could be difficult to identify during normal operation. In this case, correlation coefficients of - 0,9437 and -0,9466 have been obtained for maximum deformation and mean deformation, respectively, showing a solid relationship again.

Thus, the deformation sensing element (2.1.1), the temperature sensing element (2.1.2) and the resistor element (2.2) are connected to the terminals (3.2) through the conducting element (3). Such terminals (3.2) are connected to the PCB with the rest of the elements necessary for the calculation of the deformation and the temperature of the outside surface of the bag (1.1).

Thus, the temperature sensing element (2.1.2) being square and located in the center of the bag (1.1) provides an accurate temperature reading without being altered by the cell deformation. In the case of the deformation sensing element (2.1.1), it is placed where the deformation is maximum, forming a Wheatstone bridge with the resistor element (2.2) placed where the deformation is minimal. In the resistor element (2.2), the resistance changes with temperature, so the data obtained exclusively by the deformation in the deformation sensing element (2.1.1) are deduced.

With these measurement data and using an algorithm, the SoH and SoC of the battery are estimated, achieving a better management of the energy performance, and constituting an additional parameter to manage the increase of the battery life.

## Claims

1. Electrochemical cell (1) in the form of a bag (1.1) constituting an electric battery, comprising:
- a sensor (2) fixed to the outside surface of the bag (1.1) comprising a plurality of sensing elements (2.1.1, 2.1.2) of the same material, at least one conducting element (3) and, optionally, at least one resistor element (2.2), the conducting element (3) connecting the sensing element (2.1) and/or the resistor element (2.2) together,
wherein
- the sensing element, the conducting element (3) and/or the resistor element (2.2) are respectively obtained by separately depositing portions of material of sensing element, of conducting element (3) or of resistor element (2.2) on the outside surface of the bag (1.1).

2. Cell (1), according to the preceding claim, wherein the deformation (2.1.1) and/or temperature (2.1.2) sensing element is constituted by piezoresistive and/or thermoresistive material deposited on the outside surface of the bag (1.1).

3. Cell (1), according to any one of the preceding claims, wherein the temperature sensing element (2.1.2) is substantially arranged in the center of the bag (1.1).

4. Cell (1), according to claim 3, wherein the temperature sensing element (2.1.2) is substantially square in shape.

5. Cell (1), according to any one of the preceding claims, wherein the deformation sensing element (2.1.1) and the resistor element (2.2) are connected to form a Wheatstone bridge.

6. Cell (1), according to any one of the preceding claims, wherein the deposition of the material of the sensing (2.1), resistor (2.2) or conducting (3) element is made by sputtering or printing.

7. Cell (1), according to the preceding claim, wherein the sensing element (2.1.1, 2.1.2), resistor element (2.2) and/or conducting element (3) are arranged forming different respective layers on the outside surface of the bag (1.1).

8. Cell (1), according to any one of the preceding claims, wherein the sensor (2) comprises a passivating layer (4) applied on the sensing element (2.1.1, 2.1.2), resistor element (2.2) and conducting element (3).

9. Cell (1), according to any one of the preceding claims, wherein it has an anode constituted by lithium metal.

10. Cell (1), according to any one of the preceding claims, wherein it is selected from a lithium sulfur, lithium air, solid-state lithium ion or lithium-NMC cell.

11. Battery with detection of SOH and SOC comprising at least one cell (1) according to any one of the preceding claims.

## Patentansprüche

1. Elektrochemische Zelle (1) in Form eines Beutels (1.1), der eine elektrische Batterie bildet, umfassend:
- einen Sensor (2), der an der Außenfläche des Beutels (1.1) befestigt ist, umfassend eine Vielzahl von Messelementen (2.1.1, 2.1.2) aus demselben Material, zumindest ein leitfähiges Element (3) und optional zumindest ein Widerstandselement (2.2), das leitfähige Element (3) verbindet das Messelement (2.1) und/oder das Widerstandselement (2.2) miteinander,
wobei
- das Messelement, das leitfähige Element (3) und/oder das Widerstandselement (2.2) durch jeweils separates Aufbringen von Materialteilen des Messelements, des leitfähigen Elements (3) oder des Widerstandselements (2.2) auf die Außenfläche des Beutels (1.1) erhalten werden.

2. Zelle (1) gemäß dem vorstehenden Anspruch, wobei das Verformungs- (2.1.1) und/oder Temperaturmesselement (2.1.2) aus piezoresistivem und/oder thermoresistivem Material besteht, das auf der Außenfläche des Beutels (1.1) aufgebracht ist.

3. Zelle (1) gemäß einem der vorstehenden Ansprüche, wobei das Temperaturmesselement (2.1.2) im Wesentlichen in der Mitte des Beutels (1.1) angeordnet ist.

4. Zelle (1) gemäß Anspruch 3, wobei das Temperaturmesselement (2.1.2) im Wesentlichen eine quadratische Form hat.

5. Zelle (1) gemäß einem der vorstehenden Ansprüche, wobei das Verformungsmesselement (2.1.1) und das Widerstandselement (2.2) miteinander verbunden sind um eine Wheatstone-Brücke zu bilden.

6. Zelle (1) gemäß einem der vorstehenden Ansprüche, wobei die Abscheidung des Materials des Messelements (2.1), des Widerstandselements (2.2) oder des leitfähigen Elements (3) durch Sputtern oder Drucken erfolgt.

7. Zelle (1) gemäß einem der vorstehenden Ansprüche, wobei das Messelement (2.1.1, 2.1.2), das Widerstandselement (2.2) und/oder das leitfähige Element (3) angeordnet sind um jeweils verschiedene Schichten auf der Außenfläche des Beutels (1.1) zu bilden.

8. Zelle (1) gemäß einem der vorstehenden Ansprüche, wobei der Sensor (2) eine Passivierungsschicht (4) umfasst, die auf das Messelement (2.1.1, 2.1.2), das Widerstandselement (2.2) und das leitfähige Element (3) aufgebracht ist.

9. Zelle (1) gemäß einem der vorstehenden Ansprüche, wobei sie eine Anode aufweist, bestehend aus einem Lithiummetall.

10. Zelle (1) gemäß einem der vorstehenden Ansprüche, wobei sie ausgewählt ist aus einer Lithium-Schwefel-, Lithium-Luft-, Festkörper-Lithium-Ionen- oder Lithium-NMC-Zelle.

11. Batterie mit Erkennung von SOH und SOC, die zumindest eine Zelle (1) gemäß eine der vorstehenden Ansprüche umfasst.

## Revendications

1. Cellule électrochimique (1) sous forme d'une poche (1.1) constituant une batterie électrique, comprenant :
- un capteur (2) fixé à la surface extérieure de la poche (1.1) comprenant une pluralité d'éléments de détection (2.1.1, 2.1.2) du même matériau, au moins un élément conducteur (3) et, éventuellement, au moins un élément résistif (2.2), l'élément conducteur (3) connectant entre eux l'élément de détection (2.1) et/ou l'élément résistif (2.2),
où
- l'élément de détection, l'élément conducteur (3) et/ou l'élément résistif (2.2) sont respectivement obtenus en déposant séparément des parties de matériau de l'élément de détection, de l'élément conducteur (3) ou de l'élément résistif (2.2) sur la surface extérieure de la poche (1.1).

2. Cellule (1) selon la revendication précédente, où l'élément de détection de déformation (2.1.1) et/ou de température (2.1.2) est constitué d'un matériau piézorésistif et/ou thermorésistif déposé sur la surface extérieure de la poche (1.1).

3. Cellule (1) selon l'une quelconque des revendications précédentes, où l'élément de détection de température (2.1.2) est disposé sensiblement au centre de la poche (1.1).

4. Cellule (1) selon la revendication 3, où l'élément de détection de température (2.1.2) est de forme sensiblement carrée.

5. Cellule (1), selon l'une quelconque des revendications précédentes, où l'élément de détection de déformation (2.1.1) et l'élément résistif (2.2) sont connectés pour former un pont de Wheatstone.

6. Cellule (1), selon l'une quelconque des revendications précédentes, où le dépôt du matériau de l'élément de détection (2.1), de résistance (2.2) ou conducteur (3) est réalisé par pulvérisation cathodique ou impression.

7. Cellule (1), selon la revendication précédente, où l'élément de détection (2.1.1, 2.1.2), l'élément résistif (2.2) et/ou l'élément conducteur (3) sont disposés de manière à former différentes couches respectives sur la surface extérieure de la poche (1.1).

8. Cellule (1), selon l'une quelconque des revendications précédentes, où le capteur (2) comprend une couche de passivation (4) appliquée sur l'élément de détection (2.1.1, 2.1.2), l'élément résistif (2.2) et l'élément conducteur (3).

9. Cellule (1), selon l'une quelconque des revendications précédentes, où elle a une anode constituée de métal lithium.

10. Cellule (1), selon l'une quelconque des revendications précédentes, où elle est choisie parmi une cellule au lithium-soufre, au lithium-air, au lithium-ion à l'état solide ou au lithium-NMC.

11. Batterie avec détection de SOH et SOC comprenant au moins une cellule (1) selon l'une quelconque des revendications précédentes.
